Europäisches Patentamt

European Patent Office

Office européen des brevets

(11) Publication number: **0 166 551**
**B1**

## (12) EUROPEAN PATENT SPECIFICATION

(45) Date of publication of patent specification: **17.11.88**

(21) Application number: **85304115.0**

(22) Date of filing: **11.06.85**

(51) Int. Cl.⁴: **H 04 B 1/66**

(54) Improvements in multicoupler systems.

(30) Priority: **14.06.84 GB 8415246**

(43) Date of publication of application:
**02.01.86 Bulletin 86/01**

(45) Publication of the grant of the patent:
**17.11.88 Bulletin 88/46**

(84) Designated Contracting States:
**AT BE CH DE FR GB IT LI LU NL SE**

(56) References cited:
**EP-A-0 061 351**
**US-A-4 112 394**

**N.T.I.S. TECHNICAL NOTES, no. A-K, June
1984, page 376, Springfield, Virginia, US; U.S.
ARMY MATERIEL DEVELOPMENT AND
READINESS COMMAND: "VHF Frequency-
Hopping Multiplexer"**

(73) Proprietor: **Airtech Limited
Haddenham Aylesbury
Buckinghamshire HP17 8JD (GB)**

(72) Inventor: **Mason, Harold Peter
5 Cheriton Close Horndean
Portsmouth Hampshire P08 9PG (GB)**
Inventor: **Rolfe, Stephen Kenneth
55 Stocklake
Aylesbury Buckinghamshire HP20 1DA (GB)**

(74) Representative: **Morton, Colin David et al
Keith W Nash & Co. Pearl Assurance House
90-92 Regent Street
Cambridge CB2 1DP (GB)**

Courier Press, Leamington Spa, England.

## Description

### Field of the Invention

This invention relates to a multicoupler system. A multicoupler, as the term is conventionally used herein, means a plurality of couplers in the field of communications systems each for coupling a plurality of transmitter/receivers (transceivers) operating at differing R.F. frequencies to a common aerial.

### Background to the Invention

In the field of communications it is commonly desired for any one of a plurality of stations to be able to intercommunicate with any one or more of the other stations, with as many communications channels open at the same time as is required, and without interference between simultaneously open channels. Each channel therefore has an allotted R.F. carrier frequency, and each station has a bank of transceivers which can be simultaneously operational in different channels of communication.

This would normally mean that each station should be equipped with a corresponding bank of aerials, each individually matched to suit transmission and reception on a given communications channel.

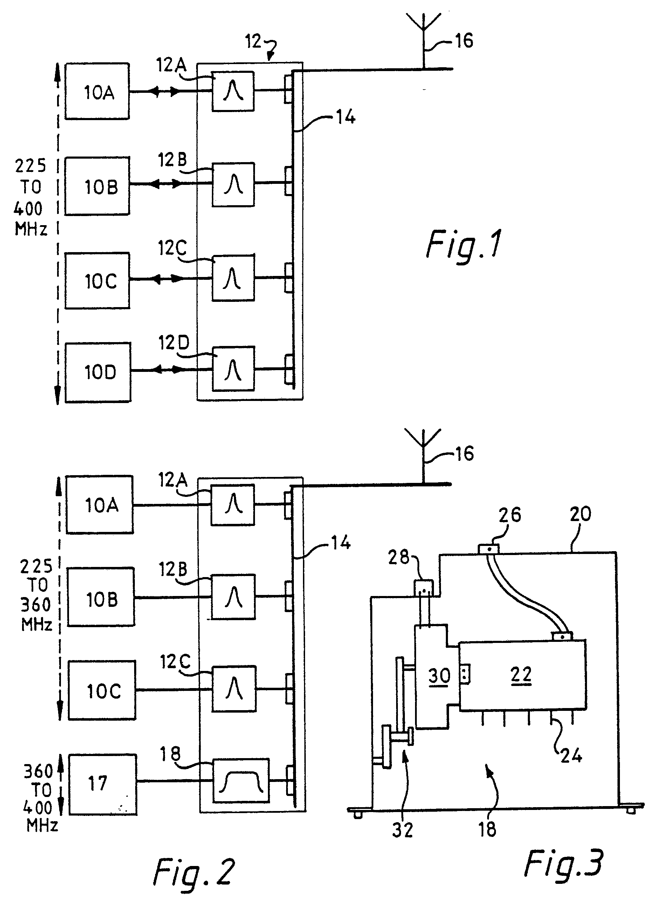

A multicoupler system, as exemplified by Figure 1, enables a single aerial to be employed at each station for a multiple channel communications system of the type described above, which is, for example, commonly employed to enable intercommunication between ships of a fleet, possibly together with one or more land stations. U.S. Patent No. 4112394 exemplifies one such known multicoupler system.

Increasingly, moreover, it is desired for such a communications system to be at least partially protected against jamming or, less importantly, against eaves-dropping.

Such protection can be afforded by frequency hopping. With frequency hopping, the R.F. carrier frequency is repetitively changed, for example ten to fifteen times a second, in accordance with a pre-arranged frequency plan which is followed at both ends of a communications channel.

At the present time, however, a multicoupler system, which incorporates single frequency tuning circuits, prohibits the use of frequency hopping.

### The Invention

According to the invention, a multicoupler system is provided comprising a plurality of couplers each for coupling a plurality of transceivers to a common aerial, each coupler corresponding to a single frequency channel having a frequency range not overlapping the frequency range of other channels, for which purpose each said channel conventionally has an allocated single R.F. carrier frequency, characterised in that the conventional coupler for at least one channel is replaced by a broad bandpass filter for enabling frequency hopping of the R.F. carrier frequency anywhere within the frequency band defined by the broad bandpass filter.

The invention thereby allows the transceiver connected to the coupler constituted by such broad bandpass filter to operate with frequency hopping, within the allotted frequency range of the broad bandpass filter from which operation of the other channels is precluded.

Typically, for example, a conventional multicoupler system has channels which can be operational each anywhere in the 225 to 400 MHz (UHF) frequency range. In accordance with the invention, one channel may be restricted to frequency hopping within the range of a broad bandpass filter from 360 to 400 MHz, and the operation of the other channels is excluded from this latter range.

In some circumstances, it will also be possible to replace the single frequency tuning coupler in at least one further channel by a broad bandpass filter covering a different 40 MHz range, excluding operation of the remaining channels from the two or more broad bandpass ranges.

The multicoupler system of this invention enables slow frequency hopping, typically 10 to 15 changes per second, or frequency hopping at a substantially faster rate, in at least one channel.

### Description of drawings

In the accompanying drawings:

Figure 1 shows the circuit diagram of a conventional multicoupler system;

Figure 2 shows the circuit diagram of a modified multicoupler system in accordance with this invention, in similar diagrammatic manner; and

Figure 3 diagrammatically illustrates in plan the construction of a broad bandpass filter installed in a coupler, in accordance with the present invention.

### Description of the Embodiment

In the conventional multicoupler circuit of Figure 1, a plurality of UHF transceivers are referenced 10A, 10B...., the multicoupler system is referenced 12 and the single frequency tuning couplers therein, any one operational in the range 225 to 400 MHz, are referenced 12A, 12B.... Each coupler 12A, 12B.... incorporates a T-coupler which connects the corresponding tuning circuit thereof to a common aerial line leading to a single aerial 16.

In the modified multicoupler circuit in accordance with the invention, shown in Figure 2, UHF transceiver 10D is replaced by a transceiver 17 which performs frequency hopping, in accordance with a frequency plan, in the range 360 to 400 MHz. The single frequency tuning coupler 12D is replaced by a broad bandpass filter 18 covering the range 360 to 400 MHz, whilst operation of the transceivers 10A, 10B, 10C is now restricted to lie within the range 225 to 360 MHz. The common aerial connection and single aerial are again respectively referenced 14 and 16.

Figure 3 shows a practical construction of the broad bandpass filter 18 incorporated in a multicoupler cabinet 20. The cabinet 20 has a plurality of "drawers" for the usual single frequency tuners, and the broad bandpass filter 18 takes the form of a substitute "drawer".

More particularly, the broad bandpass filter constituting, the coupler 18 comprises a copper box 22 with screw-adjustable trimmers 24 used for initial setting up of one filter, and with an input/output 26 to and from the transceiver. An aerial connector 28 couples to a standard T-coupler 30, which is equipped with a geared manual adjustment device 32. The broad bandpass filter serving as coupler 18 enables access for an "agile" (frequency hopping) transceiver on to an aerial common to a plurality of channels of communication.

## Claims

1. A multicoupler system comprising a plurality of couplers each for coupling a plurality of transceivers to a common aerial, each coupler corresponding to a single frequency channel having a frequency range not overlapping the frequency range of other channels, for which purpose each said channel conventionally has an allocated single R.F. carrier frequency, characterised in that the conventional coupler (12A ... 12D) for at least one channel is replaced by a broad bandpass filter (18) for enabling frequency hopping of the R.F. carrier frequency anywhere within the frequency band defined by the broad bandpass filter.

2. A system according to claim 1, characterised by combination with a transceiver (17) connected to the broad bandpass filter (18) for said at least one channel to operate with frequency hopping within an allotted frequency range from which operation of the other channels is precluded.

3. A system according to claim 2, characterised in that the broad bandpass filter (18) covers a predetermined frequency range of about 40 MHz.

4. A system according to claim 1 or claim 2, having channels operational each anywhere in the 225 to 400 MHz frequency range, characterised in that one channel (17, 18) is restricted to frequency hopping within the range of a broad bandpass filter from 360 to 400 MHz, and the operation of the other channels (10A, 12A, 10B, 12B, 10C, 12C) is excluded from this latter frequency range.

5. A system according to any of claims 1 to 4, characterised in that the coupler for at least one further channel is constituted by a broad bandpass filter.

6. A system according to claim 5 when appendant to claim 3 or claim 4, characterised in that the broad bandpass filter for said further channel covers a frequency range of about 40MHz differing from and not overlapping the range covered by the first.

7. A system according to any of claims 1 to 5, characterised by slow frequency hopping of the order of 10 to 15 changes per second.

8. A system according to any of claims 1 to 5, characterised by fast frequency hopping exceeding 15 changes per second in at least one channel.

Patentansprüche

1. Ein Vielfachkopplersystem aus mehreren Kopplern, jeder zum Ankoppeln von mehreren Sende-Empfangs-Geräten an eine gemeinsame Antenne, wobei jeder Koppler einem einzigen Frequenzkanal mit einem den Frequenzbereich der anderen Kanäle nicht überlappenden Frequenzbereich entspricht, wozu jedem Kanal konventionell eine einzige Rundfunkfrequenz-Trägerfrequenz zugeordnet ist, dadurch gekennzeichnet, daß der konventionelle Koppler (12A ... 12D) für mindestens einen Kanal durch ein breites Bandfilter (18) ersetzt ist, damit ein Frequenzsprung der Rundfunkfrequenz-Trägerfrequenz irgendwo in dem durch das breite Bandfilter bestimmten Frequenzband ermöglicht wird.

2. Ein System nach Anspruch 1, gekennzeichnet durch die Kombination mit einem mit einem breiten Bandfilter (18) verbundenen Sende-Empfangs-Gerät (17) für mindestens diesen einen Kanal zum Betreiben mit Frequenzsprung in einem zugeordneten Frequenzbereich, aus dem der Betrieb der anderen Kanäle ausgeschlossen ist.

3. Ein System nach Anspruch 2, dadurch gekennzeichnet, daß das breite Bandfilter (18) einen vorgegebenen Frequenzbereich von etwa 40 MHz abdeckt.

4. Ein System nach Anspruch 1 oder Anspruch 2 mit Kanälen, die sämtlich irgendwo im Frequenzbereich von 225 bis 400 MHz arbeiten, dadurch gekennzeichnet, daß ein Kanal (17, 18) auf einen Frequenzsprung in dem Bereich eines breiten Bandfilters von 360 bis 400 MHz begrenzt ist, und der Betrieb der anderen Kanäle (10A, 12A, 10B, 12B, 10C, 12C) aus diesem letzteren Frequenzbereich ausgeschlossen ist.

5. Ein System gemäß irgendeinem der Ansprüche 1 bis 4, dadurch gekennzeichnet, daß der Koppler für mindestens einen weiteren Kanal durch ein breites Bandfilter dargestellt ist.

6. Ein System nach Anspruch 5 bei Abhängigkeit von Anspruch 3 oder Anspruch 4, dadurch gekennzeichnet, daß das breite Bandfilter für den weiteren Kanal einen Frequenzbereich von etwa 40 MHz unterschiedlich von und ohne Überlappung des durch das erste abgedeckten Bereichs abdeckt.

7. Ein System nach irgendeinem der Ansprüche 1 bis 5, gekennzeichnet durch einen langsamen Frequenzsprung in der Größenordnung von zehn bis fünfzehn Änderungen pro Sekunde.

8. Ein System nach irgendeinem der Ansprüche 1 bis 5, gekennzeichnet durch einen fünfzehn Änderungen pro Sekunde in mindestens einem Kanal übersteigenden schnellen Frequenzsprung.

Revendications

1. Système multicoupleur comprenant une pluralité de coupleurs servant à accoupler respectivement une pluralité d'émetteurs-récepteurs à une antenne commune, chaque coupleur correspondant à un seul canal de fréquences comportant une bande de fréquences ne chevauchant pas la bande de fréquences d'autres canaux, une seule fréquence porteuse radioélectrique étant allouée à cet effet, de façon classique, à chaque canal, caractérisé en ce que le coupleur classique (12a ... 12d) prévu pour au moins un canal est remplacé par un filtre passe-bande (18) à large bande, permettant un saut de la fréquence porteuse radioélectrique en n'importe quel endroit dans la bande de fréquences définie par le filtre passe-bande à large bande.

2. Système selon la revendication 1, caractérisé par sa combinaison avec un émetteur-récepteur (17) raccordé au filtre passe-bande (18) à large bande pour qu'au moins ledit canal fonctionne avec un saut de fréquence dans une gamme allouée de fréquences, dans laquelle les autres canaux ne peuvent pas fonctionner.

3. Système selon la revendication 2, caractérisé en ce que le filtre passe-bande (18) à large bande couvre une gamme prédéterminée de fréquences d'environ 40 MHz.

4. Système selon la revendication 1 ou 2, comportant des canaux dont chacun peut fonctionner en n'importe quel emplacement dans la bande de fréquences de 225 à 400 MHz, caractérisé en ce qu'un canal (17, 18) est limité à un saut de fréquences dans la bande du filtre passe-bande à large bande, qui s'étend de 360 à 460 MHz, et que le fonctionnement des autres canaux (10A, 12A, 10B, 12B, 10C, 12C) est exclu de cette dernière bande de fréquences.

5. Système selon l'une quelconque des revendications 1 à 4, caractérisé en ce que le coupleur prévu pour au moins un autre canal est constitué par un filtre passe-bande à large bande.

6. Système selon la revendication 5, considéré comme dépendante de la revendication 3 ou 4, caractérisé en ce que le filtre passe-bande à large bande prévue pour ledit autre canal couvre une bande de fréquences d'environ 40 MHz, qui diffère de la bande couverte par le premier canal et ne la chevauche pas.

7. Système selon l'une quelconque des revendications 1 à 5, caractérisé par un saut de fréquence à cadence faible de l'ordre de 10 à 15 variations par seconde.

8. Système selon l'une quelconque des revendications 1 à 5, caractérisé par un saut de fréquence à cadence rapide dépassant 15 variations par seconde dans au moins un canal.

EP 0 166 551 B1

Fig.1

Fig.2

Fig.3

1